# EUROPEAN PATENT SPECIFICATION

(11) **EP 0 492 203 B1**
(45) Date of publication and mention of the grant of the patent: **09.08.1995**
(21) Application number: 91120893.2
(22) Date of filing: 05.12.1991
(51) Int. Cl.: H01R 13/629, H05K 7/14

(54) **Device for connecting and disconnecting an electrical connector**
Vorrichtung zum Stecken und Ziehen eines elektrischen Verbinders
Dispositif pour connecter et déconnecter un connecteur électrique

(30) Priority: 28.12.1990 DE 4042060
(43) Date of publication of application: 01.07.1992
(73) Proprietor: INTERNATIONAL BUSINESS MACHINES CORPORATION, Armonk, NY 10504 (US)
(72) Inventor: Kaiser, Lutz, Dipl.-Ing., D-71083 Herrenberg (DE); Kimmerle, Eugen, D-71088 Holzgerlingen (DE); Mirbach, Erich, D-71065 Sindelfingen (DE); Notter, Frank, Dipl.-Ing., d-71154 Nufringen (DE)
(74) Representative: Schäfer, Wolfgang, Dipl.-Ing.

(56) References cited:
- EP-A- 0 033 616
- US-A- 4 549 334

## Description

The present invention concerns a device for connecting and disconnecting an electrical connector according to the preamble of claim 1.

In practice, electrical connectors have to meet special requirements. They must be designed such that their contacts do not become disconnected when subjected to different loads and stresses, such as those imposed by vibration, temperature differences, etc. In addition they must be user friendly, i.e. the must be easy to connect and disconnect.

To meet such requirements, connectors must comprise latch means for connection and disconnection. Such means ensure that contacts are reliably closed and prevented from automatically opening during operation.

European patent application 0 369 025 describes a device by which cards can be connected to and disconnected from a board. This device comprises a resilient latch member which is connected to the card and has a movable end portion, and an operating lever which is pivotably arranged on the card. Operating lever and latch member are positioned relative to each other such that when the operating lever is actuated, its curved surface causes the latch member to perform a translatory movement, so that card and board are electrically connected. The movable end portion then drops into a groove provided on the operating lever where it remains so that the card is fixed in that position.

This prior art device has the disadvantage that the insertion force is permanently exerted on the board, so that, while the card is connected, the board is subject to considerable stress. In addition, it cannot avoided that the great number of contacts to be made by the connector increases the insertion force such that it bends the board. A board permanently bent in that way develops cracks which damage the printed conductor circuits. Another disadvantage is that for the previously described reasons the connector is only suitable for a limited number of contacts, so that large cards with very many contacts cannot be latched by the prior art device. As a result, the functions involved have to be distributed over several cards, which in turn necessitates larger housings.

Another device for latching and disconnecting an electrical connector is described by the applicant on page 6 of a catalogue "System Support: Parts Catalogue 9404" for "IBM System AS/400" under the heading "Card Enclosure Assembly". This device consists of latches, arranged in the upper and lower corners of the card or the protection housing, and of catch means fixed to the housing. A catch means is functionally associated with each latch such that the latch is capable of engaging the catch means only after card and board have been electrically connected. A primary disadvantage of this device is that the pressure required for connecting card and board is exerted on the connector components during their entire operation.

A further device of the same kind is described in EP-A-0 333 614. In addition, the afore-mentioned devices have the same disadvantages.

Therefore, it is the object of the invention to provide a device for connecting and disconnecting an electrical connector, which allows linking connectors with a maximum number of contacts and in which the force required therefor is not permanently exerted on the connector components but is largely eliminated.

This object is basically accomplished by the features specified in the characterizing part of claim 1.

Special embodiments of the device according to the invention may be seen from the subclaims.

The advantages obtained by the invention are in particular that the device constituting its subject matter allows linking connectors with a very large number of contacts. The surface areas of the connector components are subject to pressure only during connection. Once electrical connection has been made, the pressure exerted on the connector largely disappears. This permits increasing the functional density of cards used, for example, in data processing. The advantage of this is that the space required for card storage is reduced and that smaller size boards may be used. In addition, particular functions on the board are rendered superfluous, as fewer cards are required. This, in turn, simplifies in particular the production of the cards.

The device according to the invention will be described in detail below by way of a data processing application, in particular for connecting cards to a board, as shown in the accompanying drawings, in which
- Fig. 1: is a perspective view of the housing accommodating the board and the cards, with cards and board being connected by the device according to the invention,
- Fig. 2: is a perspective exploded view of the device according to the invention,
- Fig. 3: is a partly cross-sectional side view of the device according to the invention in a phase during which the pressure required for electrically connecting card and board is exerted on the board,
- Fig. 4: is a partly cross-sectional side view of the device according to the invention in a phase during which the pressure required for establishing contact between card and board is largely eliminated by the device according to the invention,
- Fig. 5: is a perspective view of a partial region of the device according to the invention, which serves to reduce the pressure between board and card, and
- Fig. 6: is a perspective view of the device according to the invention with several cards arranged in parallel.

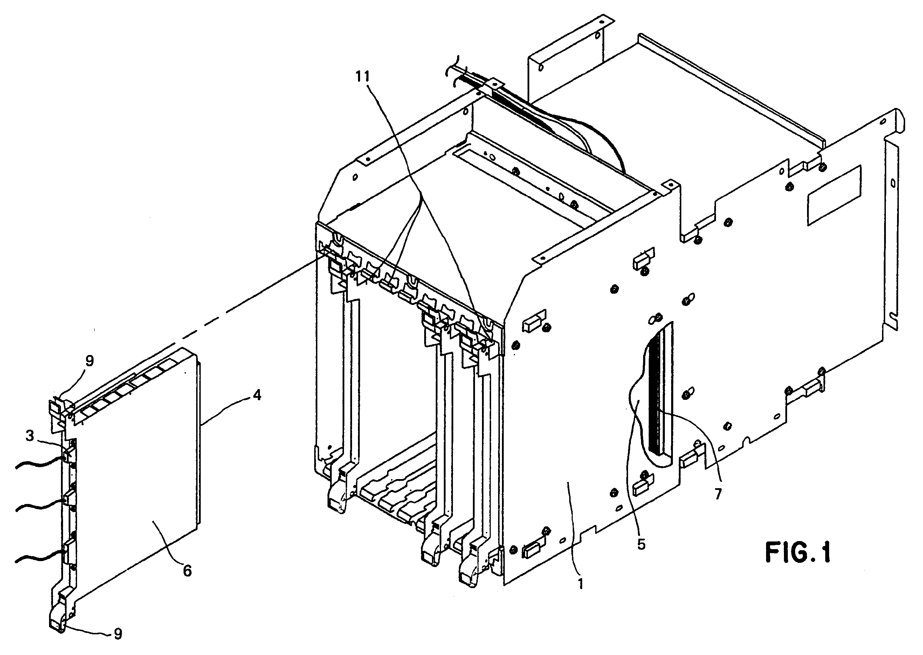

Fig. 1 shows one or several cards 3 inserted in parallel in a housing 1 where they are connected to a board 5. The cards 3, in particular electronic cards, are generally accommodated in a protection housing 6 shielding them against electromagnetic radiation. Protection housing 6 has an aperture from which a contact connector part 4, linked with a contact connector part 7 of the board 5, protrudes. The top and the bottom corner on one side of the protection housing 6 are fitted with one latch 9 each which is pivotably supported on housing 6. If the protection housing 6 for shielding the card 3 is dispensed with for technical reasons, latch 9 may be fixed to the card 3 directly.

The upper and the lower region of the housing 1 are provided with catch bars 11 which are engaged by latches 9 only after the contact connector part 7 of the board 5 and the contact connector part 4 of the card 3 have been electrically connected. Latch bars 11 may be arranged on housing 1 individually or jointly.

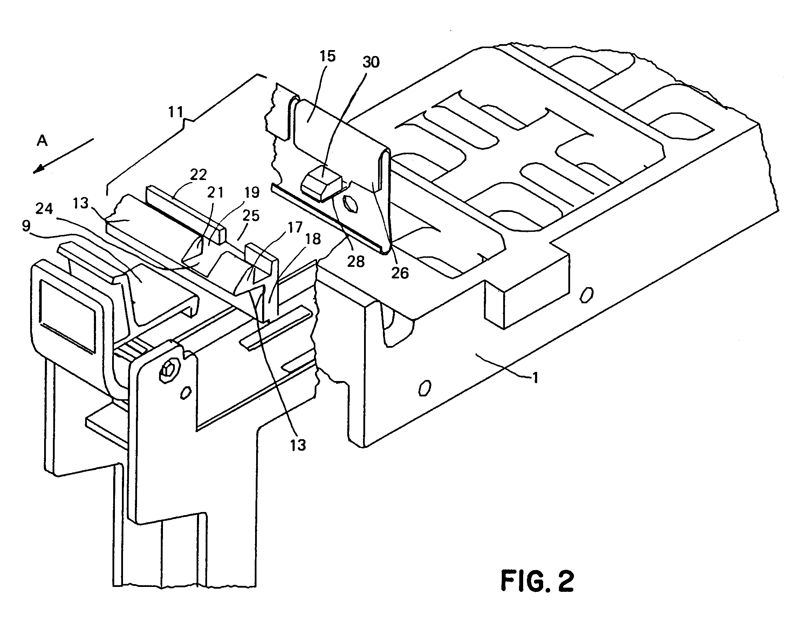

Fig. 2 shows how the individual parts of the device according to the invention are associated.

Catch bar 11 consists of an inflexible catch element 13 and a flexible catch element 15 which may be a U-shaped spring. The inflexible catch element 13 is fixed to housing 1. The flexible catch element 15 is designed as an independent element and arranged on the inflexible catch element 13. The inflexible catch element 13 has two legs 17, 18 extending orthogonally to each other, the inflexible catch element 13 being positioned on housing 1 such that one leg 18 is arranged parallel to housing 1 whereas the other leg 17 extends orthogonally to leg 18. The upper region of leg 17 is provided with a recess 19 so that two bars 21, 22, extending parallel to each other and the surface of leg 18, connected to housing 1, are formed on either side. The two bars 21, 22 are interrupted by a further recess 24, 25. The U-shaped spring 15 is fixed to the inflexible catch element 13 such that the two legs of spring 15 enclose bar 22 so that the bent portion of the spring 15 rests against the inside of bar 22. For spring 15, bar 22 acts as a stop. One leg 26 of the spring 15 is provided on its movable end with a tongue 28 projecting from spring 15 and which is positioned orthogonally to leg 26 of the spring 15. On this tongue 28, a cam 30 is arranged. Spring 15 is positoned on bar 22 such that the projecting tongue 28 is reciprocally movable parallel to the base of the recess 24 between bars 21, 22.

Bar 21 is ramp-shaped so that latch 9 may be readily moved across bar 21. Cam 30 determines the point up to which latch 9 has to be moved for electrical connection. Having reached that point, latch 9 snaps into place behind cam 30. As cam 30 is suspended from a spring 15, latch 9 along with the associated card 3 moves back in the direction of arrow A opposite that of the insertion force up to a point at which the pressure on the connector is almost zero. Disconnection of the connector is also prevented by the fact that the width of latch 9 enclosing cam 30 exceeds the size of the recess 24 in bar 21, so that the return movement of latch 9 with the card 3 is stopped on the inside of the bar 21.

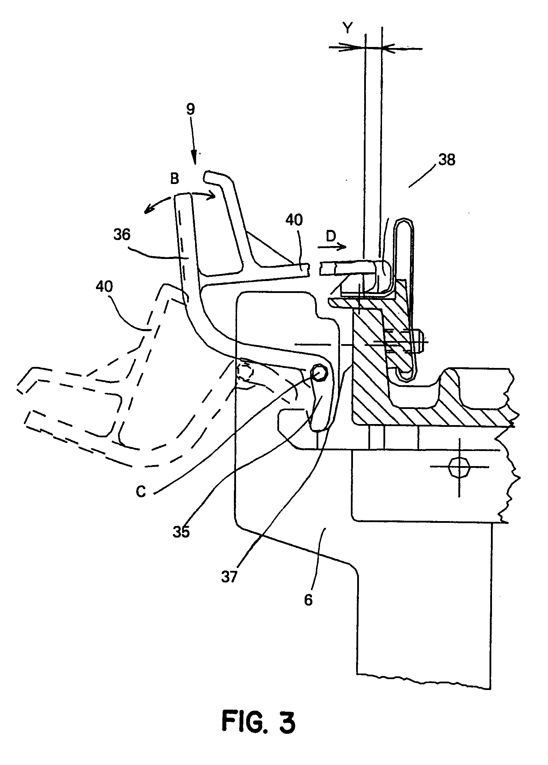

Fig. 3 shows the device according to the invention as card 3 and board 5 are being connected. Latches 9 are arranged in the upper and lower corners of the protection housing 6. If the protection housing is omitted for technical reasons, latches 9 may be arranged on the card 3 directly. Latches 9 are pivotably positioned on housing 6. They are pivotable about an axis C such that they are subdivided into two lever arms 35 and 36 of different length, which are arranged in S-shape relative to each other.

The longer lever arm 36 of latch 9 is moved by hand or other means in the direction of arrow B. The short lever 35 of latch 9 engages a recess 37 on housing 1 as soon as the protection housing 6 with the card 3 arranged thereon is in engagement. A latch pawl 40, whose end is provided with a perpendicular latch nose 38, is arranged on the longer lever arm 36. The short lever arm 35 acts as a toggle lever, i.e. when the longer lever arm 36 with the latch pawl 40 for engaging cam 30 is moved in the direction of arrow D, the short lever arm 35 engages the recess 37 in housing 1, leading to an additional insertion force being exerted on the card and the protection housing 6. This additional force electrically connects the contact connector part 4 of the card to the contact connector part 7 of the board 5. Then, latch pawl 40 engages cam 30 with its latch nose 38.

The magnitude of the force required for connecting card 3 and board 5 is determined by the position of cam 30, i.e. the position of cam 30 determines the additional distance Y by which the card has to be moved before the latch nose 38 of the pawl 40 is capable of engaging cam 30. The insertion force must at least exceed the sum of the spring and frictional forces of the connector contacts. The load the insertion force exerts on the card 3 and the board 5 disappears immediately after the spring forces of the connector contacts have been overcome. To this end, the movable cam 30 is used which balances the pressure between card 3 and board 5.

The insertion force required depends upon the number of contacts to be made when card 3 and board 5 are connected and the position of cam 30 on the inflexible catch element 13. Thus, the device according to the invention is adaptable to connectors with varying numbers of contacts.

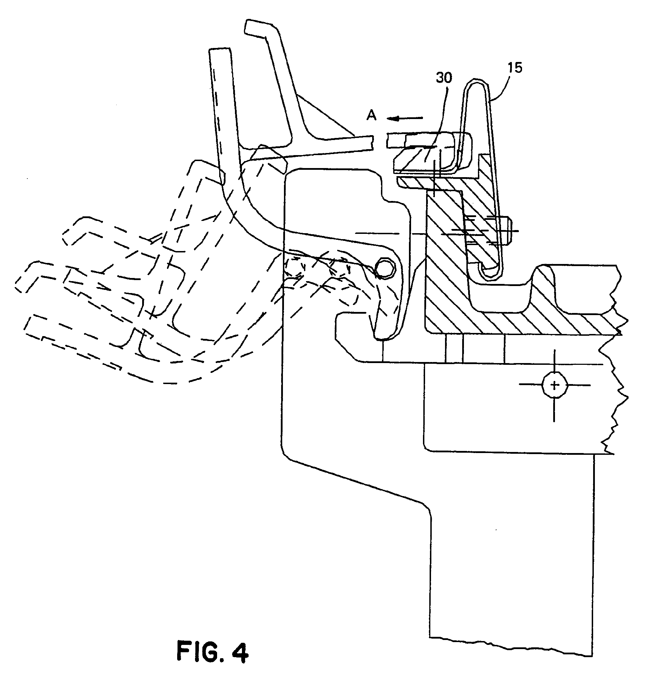

Fig. 4 shows the device according to the invention in the unloaded state, i.e. after card 3 and board 5 have been electrically connnected.

The movable cam 30 balances the pressure between card 3 and board 5. As a result of this and the change in the position of cam 30 in the direction of arrow A, the spring 15, supporting cam 30, is tensioned. Spring 15 is designed such that contacts are not inadvertently opened. For this purpose, the force required for further tensioning the spring 15 must exceed the sum of the frictional forces opening the contacts.

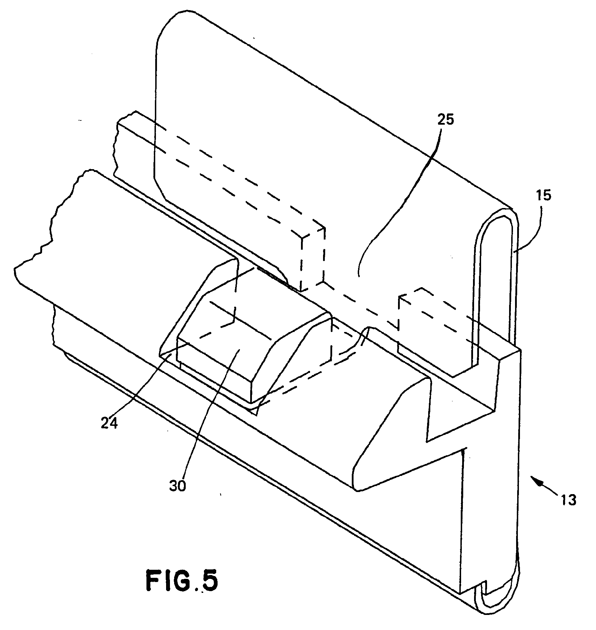

Fig. 5 shows in particular the function of recesses 24, 25 on the inflexible catch element 13. Recess 24 allows cam 30 to move on the inflexible catch element 13 such that the pressure between card 3 and board 5 is balanced.

The device according to the invention renders an inflexible catch element 13 superfluous, so that spring 15 and cam 30 may be fixed to housing 1, for example. It is also technically feasible for the inflexible catch element 13 to consist of a flat plate which is directly connected to housing 1. In this case, spring 15 would surround the plate such that it is self-supporting thereon.

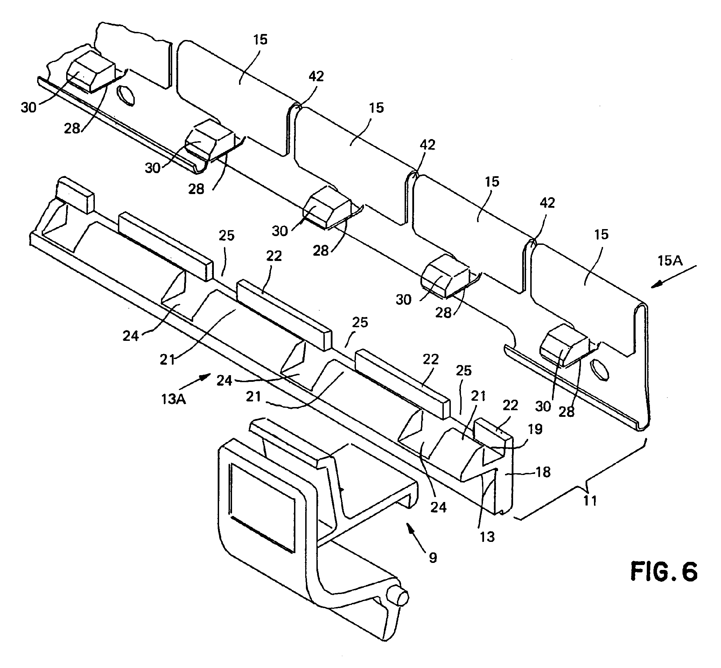

Fig. 6 shows in particular the design of the spring 15 and the inflexible catch element 13 for several cards 3 arranged in parallel. Spring 15 consists of one part 15a, its legs being separated from each other by a recess 42 so that one movable spring leg is associated with each card 3 or latch 9. Each spring leg is fitted with a tongue 28 and a cam 30 positioned thereon. The inflexible catch element also consists of one part 13a and has an elongated recess 19 forming two bars 21, 22, arranged parallel to each other, over the entire length of the inflexible catch part 13a. Each spring leg is also associated with a further recess 24, 25 which allows cam 30 to move for reducing the pressure between card 3 and board 5. Recess 24 is positioned such that the two bars 21, 22 are interrupted. The size of the interruption allows cam 30 to pass.

In summary, the advantages of the device according to the present invention are that in particular for connector contacts connected by applying a predetermined force, the packing density of the card is almost insignificant. The present invention allows the connection of cards of maximum packing density without the board to which they are connected being damaged by the insertion force. Further advantages are that the device according to the invention is easy and inexpensive to produce.

## Claims

1. Device for connecting and disconnecting an electrical connector,
wherein the connector consists of a movable (3, 6) and a fixed element (5), the movable element (3, 6) being guided in a housing (1) and being moved at a predetermined insertion force until the movable (3, 6) and the fixed element (5) are electrically connected,
comprising at least two movably supported latches (9) which are separately supported on the movable element (3, 6), and at least two catch bars (11) which are separately arranged on the housing (1) so that each latch (9) is functionally associated with one catch bar (11), the latches (9) and the catch bars (11) being positioned relative to each other such that the latches are capable of engaging the catch bars only after the movable and the fixed elements are electrically connected,
characterized in that at least the element (15) of the catch bar (11) engaged by the latch (9) is flexibly designed to be flexible in the direction of insertion of the movable element.

2. Device as claimed in claim 1,
characterized in that catch bar (11) consists of a flexible catch element (15) and an inflexible catch element (13).

3. Device as claimed in claim 1 or 2,
characterized in that the flexible catch element (15) consists in particular of a U-shaped spring (15), wherein one leg of the spring is rigidly positioned on the housing (1) or the inflexible catch element (13), and the inflexible element (13) is connected to the housing (1), the open end of the other leg (26) being provided with a cam (30) which is engaged by latch (9).

4. Device as claimed in claim 2 or 3,
characterized in that the inflexible catch element (13) is shaped in particular in the form of a plate, and that the two legs of the U-shaped spring (15) surround the plate such that the spring (15) is self-supporting thereon.

5. Device as claimed in claim 2 or 3,
characterized in that the inflexible catch element (13) is fixed to a surface of the housing (1), one part (17) of the inflexible element (13) extending transversely to and another part (18) resting on the housing surface, the transverse part (17) and the other part (18) being preferably arranged orthogonally to each other, and that the cam (30) is movable in the plane of the transverse part (17).

6. Device as claimed in claim 5,
characterized in that the plane of the transverse part (17) comprises two intersecting recesses (19; 24, 25), the first recess (19) being designed such that two separate bars (21, 22) are formed extending parallel to the other part (18) and which are spaced from each other (X), the second recess (24, 25) extending transversely to the first recess (19) so that the latter interrupts at least the separate bar (21) averted from the other part (18), and that the second recess (24, 25) is dimensioned such that the cam (30) is movable therein.

7. Device as claimed in claim 6,
characterized by an additional motional path of the movable element (3, 6), which is necessary for building up a predetermined pressure between the movable (3, 6) and the fixed element (5) for electrical connection.

8. Device as claimed in claim 6 or 7,
characterized in that the part of latch (9) engaging cam (30) is wider than the interruption of bar (21) averted from the other part (18), so that after electrical connection has been made the return movement of the movable element (3, 6) is limited by the separate bar (21).

9. Device as claimed in claim 6, 7 or 8,
characterized in that the bar (22) facing the part (18) serves to accommodate in particular the U-shaped spring (15).

10. Device as claimed in claim 6, 7, 8 or 9,
characterized in that the two legs of the U-shaped spring (15) surround a further separate bar (22) such that the bent portion of the spring (15) rests against the further separate bar, and that the spring (15) at the lower movable end of the leg is provided with a tongue (28) which is positioned parallel to the plane of the transverse part (17) and which is movable in the second recess (24, 25), the cam (30) being arranged on the tongue (28).

11. Device as claimed in claim 6, 7, 8, 9 or 10,
characterized in that the separate bar (21) averted form the other part (18) is in particular ramp-shaped, the sloping surface being positioned on the side averted from the other part (18).

12. Device as claimed in claims 1 to 11,
characterized in that the catch bar (11) for several connectors arranged adjacent to each other is designed such that the flexible catch elements (15) are arranged on a common part (15a), and the flexible catch elements (15) for each associated connector are designed according to any one or a combination of claims 3 to 11.

13. Device as claimed in claims 1 to 12,
characterized in that for several connectors arranged parallel to each other, one common inflexible catch part (13a) is provided for accommodating the flexible catch part (15a), and the area of the inflexible catch element (13), serving to accommodate the flexible catch element (15), is designed according to any one or a combination of claims 4 to 12.

14. Device as claimed in claim 12 or 13,
characterized in that the flexible catch part (15a) is arranged on the inflexible catch part (13a).

15. Device as claimed in any one of the claims 1 to 14,
characterized in that the movable element (3) is an electronic card and the fixed element (5) is a board, with the card being plugged onto the latter.

16. Device as claimed in claims 1 to 15,
characterized in that the card (3) is surrounded by a protection housing (6), and the latches (9) are fixed to the protection housing (6).

17. Electronic apparatus, in particular a data processing apparatus, comprising at least one card (3) and at least one board (5) which are connected to each other by a device for connecting and disconnecting electrical connectors according to any one or a combination of the claims 1 to 16.

## Patentansprüche

1. Vorrichtung zum Verbinden und Lösen einer elektrischen Steckverbindung,
wobei die Steckverbindung aus einem beweglich (3, 6) und einen fest angeordneten Teil (5) besteht, wobei das bewegliche Teil (3, 6) in einem Gehäuse (1) geführt wird und mittels einer bestimmten Einschubkraft soweit bewegt wird bis das bewegliche (3, 6) und unbewegliche Teil (5) eine wirksame Verbindung eingegangen sind,
bestehend aus zumindest zwei beweglich gelagerten Rasthebeln (9), die voneinander getrennt am beweglichen Teil (3, 6) gelagert sind und zumindest zwei Sperren (11), die voneinander getrennt am Gehäuse (1) angeordnet sind, so daß jedem Rasthebel (9) funktionell eine Sperre (11) zugeordnet ist, wobei die Rasthebel und die Sperren (11) so zueinander angeordnet sind, daß die Rasthebel erst dann mit den Sperren in Eingriff kommen können, wenn eine wirksame Verbindung zwischen beweglichem und unbeweglichem Teil hergestellt ist,
dadurch gekennzeichnet,
daß zumindest derjenige Teil (15) der Sperre (11), der mit dem Rasthebel (9) in Eingriff kommt, flexibel in der Einschubrichtung des beweglichen Teils ausgebildet ist.

2. Vorrichtung nach Anspruch 1,
dadurch gekennzeichnet,
daß die Sperre (11) aus einem flexiblen Sperrteil (15) und einem unflexiblen Sperrteil (13) besteht.

3. Vorrichtung nach Anspruch 1 oder 2,
dadurch gekennzeichnet,
daß das flexible Sperrteil (15), insbesondere aus einer U-förmigen Feder (15) besteht, wobei ein Schenkel der Feder starr am Gehäuse (1) oder am unflexiblen Sperrteil (13) angeordnet ist und das unflexible Sperrteil (13) mit dem Gehäuse (1) verbunden ist, wobei am offenen Ende des anderen Schenkels (26) ein Mitnehmerteil (30) angebracht ist, in den der Rasthebel (9) eingreift.

4. Vorrichtung nach Anspruch 2 oder 3,
dadurch gekennzeichnet,
daß das unflexible Sperrteil (13) insbesondere die Form einer Platte hat und daß die beiden Schenkel der U-förmigen Feder (15) die Platte derart umschließen, daß die Feder (15) selbstlagernd auf der Platte sitzt.

5. Vorrichtung nach Anspruch 2 oder 3,
dadurch gekennzeichnet,
daß das unflexible Sperrteil (13) an einer Gehäusefläche des Gehäuses (1) befestigt ist, wobei das unflexible Sperrteil (13) ein zu dieser Gehäusefläche querverlaufendes (17) und ein anliegendes Teil (18) aufweist, wobei querverlaufendes (17) und anliegendes Teil (18) vorzugsweise im rechten Winkel zueinander angeordnet sind, und daß das Mitnehmerteil (30) auf der Ebene des querverlaufenden Teils (17) bewegbar ist.

6. Vorrichtung nach Anspruch 5,
dadurch gekennzeichnet,
daß die Ebene des querverlaufenden Teils (17) zwei sich kreuzende Ausnehmungen (19; 24, 25) aufweist, wobei die erste Ausnehmung (19) so gestaltet ist, daß zwei getrennte Stege (21, 22) gebildet werden, die zueinander und zum anliegenden Teil (18) parallel verlaufen und im Abstand X voneinander entfernt sind und wobei die zweite Ausnehmung (24, 25) quer zu der ersten Ausnehmung (19) angeordnet ist, so daß durch diese Ausnehmung zumindest derjenige Steg (21) unterbrochen ist, der dem anliegenden Teil (18) abgewandt ist, und das die zweite Ausnehmung (24, 25) so dimensioniert ist, daß das Mitnehmerteil (30) innerhalb der zweiten Ausnehmung (24, 25) bewegt werden kann.

7. Vorrichtung nach Anspruch 6,
dadurch gekennzeichnet,
daß ein zusätzlicher Überweg des beweglichen Teils (3, 6) festgelegt ist, der erfoderlich ist, um einen bestimmten Druck zwischen beweglichem (3, 6) und unbeweglichem Teil (5) aufzubauen, damit eine wirksame Verbindung herstellbar ist.

8. Vorrichtung nach Anspruch 6 oder 7,
dadurch gekennzeichnet,
daß derjenige Teil des Rasthebels (9) der mit dem Mitnehmerteil (30) in Eingriff kommt, breiter ist als die Ausdehnung der Unterbrechung des dem anliegenden Teil (18) abgewandten Steges (21), so daß die Rückführbewegung des beweglichen Teils (3, 6) nach dem Zustandekommen der Verbindung durch diesen Steg (21) begrenzt ist.

9. Vorrichtung nach Anspruch 6, 7 oder 8 dadurch gekennzeichnet, daß der dem anliegenden Teil (18) zugewandte Steg (22) zur Aufnahme der insbesondere U-förmigen Feder (15) dient.

10. Vorrichtung nach Anspruch 6, 7, 8 oder 9,
dadurch gekennzeichnet,
daß die beiden Schenkel der U-förmigen Feder (15) einen weiteren separaten Steg (22) derart umschließen, daß der gebogene Teil der Feder (15) am weiteren separaten Steg anliegt, und
daß die Feder (15) am unteren beweglichen Ende des Schenkels eine Zunge (28) aufweist, die parallel zur Ebene des querverlaufenden Teiles (17) angeordnet ist und innerhalb der zweiten Ausnehmung (24, 25) bewegbar ist, wobei auf der Zunge (28) das Mitnehmerteil (30) angeordnet ist.

11. Vorrichtung nach Anspruch 6, 7, 8, 9 oder 10
dadurch gekennzeichnet,
daß der dem anliegenden Teil (18) abgewandte Steg (21) insbesondere die Form einer Rampe aufweist, wobei die Schräge auf der dem anliegenden Teil (18) abgewandten Seite liegt.

12. Vorrichtung nach Anspruch 1 oder 2,
dadurch gekennzeichnet,
daß die Sperre (11) für mehrere parallel nebeneinander angeordnete Steckverbindungen insbesondere derart ausgestaltet ist, daß die flexiblen Sperrteile (15) an einem gemeinsamen Teil (15a) angeordnet sind, und die flexiblen Sperrteile (15) für jede ihr zugeordnete Steckverbindung nach einem oder mehreren der Ansprüche 3 - 11 ausgebildet sind.

13. Vorrichtung nach Anspruch 1, 2 oder 12,
dadurch gekennzeichnet,
daß für mehrere parallel nebeneinander angeordnete Steckverbindungen ein gemeinsames unflexibles Sperrteil (13a) zur Aufnahme des flexiblen Sperrteils (15a) vorgesehen ist, und derjenige Bereich des unflexiblen Sperrteils (13), der zur Aufnahme des flexiblen Sperrteils (15) dient, nach einem oder mehreren der Ansprüche 4 - 12 ausgebildet ist.

14. Vorrichtung nach Anspruch 12 oder 13,
dadurch gekennzeichnet,
daß das flexible Sperrteil (15a) auf dem unflexiblen Sperrteil (13a) angeordnet ist.

15. Vorrichtung nach einem der Ansprüche 1 bis 14,
dadurch gekennzeichnet,
daß das bewegliche Teil (3) eine elektronische Karte ist und das unbewegliche Teil (5) eine Platine ist, wobei die Karte mit der Platine in Steckkontakt bringbar ist.

16. Vorrichtung nach Anspruch 1 bis 15,
dadurch gekennzeichnet,
daß die Karte (3) von einem Schutzgehäuse (6) umgeben ist, und die Rasthebel (9) am Schutzgehäuse (6) befestigt sind.

17. Elektronikgerät, insbesondere Datenverarbeitungsgerät, enthaltend zumindest eine Karte (3) und zumindest eine Platine (5) die miteinander mittels einer Vorrichtung zum Verbinden und Lösen von elektrischen Steckverbindungen gemäß einem oder mehreren der Ansprüche 1 - 16 verbunden sind.

## Revendications

1. Dispositif pour connecter et déconnecter un connecteur électrique,
dans lequel le connecteur consiste en un élément mobile (3, 6) et un élément fixe (5), l'élément mobile (3, 6) étant guidé dans un boîtier (1) et étant déplacé avec une force d'insertion prédéterminée jusqu'à ce que l'élément mobile (3, 6) et l'élément fixe (5) soient connectés électriquement,
comprenant au moins deux dispositifs de verrouillage supportés de façon mobile (9) qui sont supportés séparément sur l'élément mobile (3, 6), et au moins deux barres de blocage (11) qui sont agencées séparément sur le boîtier (1) de telle sorte que chaque dispositif de verrouillage (9) est associé fonctionnellement avec une barre de blocage (11), les dispositifs de verrouillage (9) et les barres de blocage (11) étant positionnés les uns par rapport aux autres de telle sorte que les dispositifs de verrouillage peuvent s'engager avec les barres de blocage uniquement après que les éléments mobiles et fixes sont connectés électriquement,
caractérisé en ce qu'au moins l'élément (15) de la barre de blocage (11) engagé par le dispositif de verrouillage (9) est destiné à être flexible dans la direction d'insertion de l'élément mobile.

2. Dispositif selon la revendication 1,
caractérisé en ce que la barre de blocage (11) consiste en un élément de blocage flexible (15) et un élément de blocage non flexible (13).

3. Dispositif selon la revendication 1 ou 2,
caractérisé en ce que l'élément de blocage flexible (15) consiste en particulier en un ressort (15) en forme de U, dans lequel une patte du ressort est disposé de façon rigide sur le boîtier (1) ou l'élément de blocage non flexible (13), et l'élément non flexible (13) est connecté au boîtier (1), l'extrémité ouverte de l'autre patte (26) étant pourvue d'une came (30) qui coopère avec un dispositif de verrouillage (9).

4. Dispositif selon la revendication 2 ou 3,
caractérisé en ce que l'élément de blocage non flexible (13) se présente en particulier sous la forme d'une plaque, et en ce que les deux pattes du ressort en forme de U (15) entourent la plaque de telle sorte que le ressort (15) est auto-supporté sur celle-ci.

5. Dispositif selon la revendication 2 ou 3,
caractérisé en ce que l'élément de blocage non flexible (13) est fixé à une surface du boîtier (1), une partie (17) de l'élément non flexible (13) s'étendant transversalement à une autre partie (18) reposant sur la surface du boîtier, la partie transversale (17) et l'autre partie (18) étant de préférence disposées orthogonalement l'une par rapport à l'autre, et en ce que la came (30) est mobile dans le plan de la partie transversale (17).

6. Dispositif selon la revendication 5,
caractérisé en ce que le plan de la partie transversale (17) comprend deux cavités qui se croisent (19; 24, 25), la première cavité (19) étant telle que deux barres séparées (21, 22) sont formées s'étendant parallèlement à l'autre partie (18) et sont espacées l'une de l'autre (X), la seconde cavité (24, 25) s'étendant transversalement à la première cavité (19) de telle sorte que cette dernière interrompt au moins la barre séparée (21) cachée de l'autre partie (18), et en ce que la seconde cavité (24, 25) est dimensionnée de telle sorte que la came (30) est mobile dans celle-ci.

7. Dispositif selon la revendication 6,
caractérisé par un trajet de déplacement supplémentaire de l'élément mobile (3, 6), qui est nécessaire pour obtenir une pression prédéterminée entre l'élément mobile (3, 6) et l'élément fixe (5) pour la connexion électrique.

8. Dispositif selon la revendication 6 ou 7,
caractérisé en ce que la partie du dispositif de verrouillage (9) coopérant avec la came (30) est plus large que l'interruption de la barre (21) cachée de l'autre partie (18), de telle sorte qu'après que la connexion électrique a été réalisée le mouvement de retour de l'élément mobile (3, 6) est limité par la barre séparée (21).

9. Dispositif selon la revendication 6, 7 ou 8,
caractérisé en ce que la barre (22) en regard de la partie (18) sert à s'adapter en particulier au ressort en forme de U (15).

10. Dispositif selon la revendication 6, 7, 8 ou 9,
caractérisé en ce que les deux pattes du ressort en forme de U (15) entourent une autre barre séparée (22) de telle sorte que la partie courbe du ressort (15) repose contre l'autre barre séparée, et en ce que le ressort (15) à l'extrémité inférieure mobile de la patte est pourvu d'une languette (28) qui est disposée parallèlement au plan de la partie transversale (17) et qui est mobile dans la seconde cavité (24, 25), la came (30) étant disposée sur la languette (28).

11. Dispositif selon la revendication 6, 7, 8, 9 ou 10,
caractérisé en ce que la barre séparée (21) cachée de l'autre partie (18) est en particulier en forme de rampe, la surface inclinée étant disposée sur la face cachée de l'autre partie (18).

12. Dispositif selon les revendications 1 à 11,
caractérisé en ce que les barres de blocage (11) pour plusieurs connecteurs disposées dans des positions adjacentes les unes aux autres sont telles que les éléments de blocage flexibles (15) sont disposés sur une partie commune (15a), et les éléments de blocage flexibles (15) pour chaque connecteur associé sont configurés selon l'une quelconque ou une combinaison des revendications 3 à 11.

13. Dispositif selon les revendications 1 à 12,
caractérisé en ce que pour plusieurs connecteurs disposés parallèlement les uns aux autres, une partie de blocage commune non flexible (13a) est utilisée pour s'adapter à la partie de blocage flexible (15a), et la surface de l'élément de blocage non flexible (13), servant à s'adapter à l'élément de blocage flexible (15), est configurée selon l'une quelconque ou une combinaison des revendications 4 à 12.

14. Dispositif selon la revendication 12 ou 13,
caractérisé en ce que la partie de blocage flexible (15a) est disposée sur la partie de blocage non flexible (13a).

15. Dispositif selon l'une quelconque des revendications 1 à 14,
caractérisé en ce que l'élément mobile (3) est une carte électronique et l'élément fixe (5) est un panneau, la carte étant enfichée sur ce dernier.

16. Dispositif selon les revendications 1 à 15,
caractérisé en ce que la carte (3) est entourée d'un boîtier de protection (6), et les dispositifs de verrouillage (9) sont fixés au boîtier de protection (6).

17. Appareil électronique, en particulier appareil de traitement de données, comprenant au moins une carte (3) et au moins un panneau (5) qui sont connectés l'un à l'autre par un dispositif pour connecter et déconnecter des connecteurs électriques.
